# EUROPEAN PATENT APPLICATION

(11) **EP 3 376 828 A1**
(43) Date of publication of application: **19.09.2018**
(21) Application number: 17382137.2
(22) Date of filing: 17.03.2017
(51) Int. Cl.: H05B 33/08, H01L 33/62, H05K 1/18

(54) **LIGHTING MODULE WITH CONFIGURABLE ELECTRICAL NETWORK FOR DRIVING LIGHT SOURCE THEREOF**

(71) Applicant: Valeo Iluminacion, 23600 Martos (ES)
(72) Inventor: ARJONA, Jaime, 23600 MARTOS (ES); CALAVIA, Antonio, 23600 MARTOS (ES); SANTAELLA, Juan-Jose, 23600 MARTOS (ES); LARA-CABEZA, Juan, 23600 MARTOS (ES); PENA, Miguel-Angel, 23600 MARTOS (ES); CALMAESTRA, Manuel, 23600 MARTOS (ES); ILLAN, Antonio Domingo, 23600 MARTOS (ES)

(57) **Abstract**

A Lighting module for an automotive vehicle, comprising: a light source; a binning electrical network comprising a configurable resistance; and an electrical driver module configured to supply an electrical current to the light source through the binning electrical network. And a method for configuring a lighting module for an automotive vehicle to electrically drive a light source thereof according to predetermined characteristics of the light source, the method comprising: providing the lighting module for an automotive vehicle, the lighting module comprising: the light source with the brightness class; and an electrical driver module configured to supply an electrical current to the light source through a binning electrical network; providing the binning electrical network, the binning electrical network comprising a configurable resistance.

## Description

### TECHNICAL FIELD

The present invention relates to the field of lighting modules for automotive vehicles. More specifically, the invention relates to a lighting module with at least one light source that is electrically driven through an electrical network that may be configured according to the characteristics of the at least one light source.

### STATE OF THE ART

A light source like a light emitting diode (i.e. an LED) of a lighting module or a lighting device may function correctly when it is driven with an electrical current having an appropriate intensity. Each light emitting diode may be classified in one of many bins, each of which indicates which are the predetermined characteristics of the LED in terms of light output (color and luminous flux), and the electrical current and/or voltage that it must be supplied with in order to provide such light output. The predetermined characteristics of a light source are the light characteristics of the light source; some literature refers to the predetermined characteristics as the brightness class of the light source.

LEDs are manufactured with a process that is repeated over and over. However, due to some variations in the composition of the materials used, particularly the wafer, not all the LEDs produced have the same physical characteristics. This results in variations in the predetermined characteristics of each LED, so different light is emitted by each LED; this fact makes that the electrical current that shall drive each LED must have an intensity that is appropriate for emitting the light they may provide (according to their bin, that is, their predetermined characteristics).

As LEDs are manufactured, they are assigned to one of the many bins representing different predetermined characteristics. When an LED must be integrated within a lighting device, it is known what light it will provide and how it must be electrically driven based on the bin it has been assigned to during its production. Then, depending on the particular bin of the LED, a particular resistor (also referred to as binning resistor in the context of the present disclosure) shall be used so that the electrical current driving the LED has the appropriate intensity.

When lighting modules and/or lighting devices are produced, a light source is connected to an electrical circuit of a printed circuit board (hereinafter PCB). In the same electrical circuit, a binning resistor is mounted so that the electrical driver module supplies the appropriate electrical current to the light source. Now, as light sources may be assigned to one of a plurality of bins, it is necessary to have binning resistors of as many resistance values as there are bins, in this way when a light source of any of these bins is added to the lighting module and/or lighting device and connected to the electrical circuit, a binning resistor corresponding to the bin of the light source may be installed in the electrical circuit. This slows down the production of lighting modules and/or lighting devices as the light source and the binning resistor must match, otherwise the lighting modules and/or lighting devices may be subpar if the binning resistor does not match to the light source. Further, this has become even more cumbersome with the submount of light sources whereby a light source is first mounted on the heatsink and then on the PCB. Therefore, special care must be taken during the whole manufacturing process and the supervision of the production is costly and prone to errors as well, something which is exacerbated when the production is outsourced.

Accordingly, there is an interest in providing a lighting module for an automotive vehicle that may ease the production thereof by having an electrical network (that is, an electrical network that conditions the electrical current driving a light source) that may be configured to the predetermined characteristics of a light source (that is, the bin corresponding to the light source) in the lighting module. There is also an interest in providing a method for configuring such lighting module to electrically drive a light source thereof according to the predetermined characteristics of the light source.

### DESCRIPTION OF THE INVENTION

A first aspect of the invention refers to a lighting module for an automotive vehicle, comprising: a light source; a binning electrical network comprising a configurable resistance; and an electrical driver module configured to supply an electrical current to the light source through the binning electrical network.

The lighting module may be configured so as to electrically drive the light source according to predetermined characteristics of the light source. Accordingly, during the production of the lighting module, an electrical driver module, a light source and an electrical network may be all installed in the lighting module and, afterwards, the lighting module may be configured by making the necessary adjustments in the binning electrical network (by binning electrical network it is understood an electrical network for regulating the electrical current that drives a light source; the terms "binning electrical network" and "electrical network" are equivalent and are interchangeably used throughout the present disclosure).

The lighting module may be more costly due to the addition of an electrical network with a configurable resistance, however the additional cost may be less than the cost of providing a manufacturing line capable of identifying the predetermined characteristics of the light source, selecting a particular resistor with a resistance associated with the predetermined characteristics, installing the particular resistor. Moreover, there are additional costs for providing such manufacturing line: the cost of the free space necessary for storing all the part numbers, the cost of a more complex quality control, and the cost of any lighting module that is manufactured incorrectly, that is, any lighting module whose resistor of the electrical network does not correspond to the predetermined characteristics of the light source.

The resistance of the electrical network is configurable, and thus it may be programmed during the production of the lighting module or even once the lighting module has been manufactured. This, in turn, simplifies the production of such modules and permits that more cost-effective supervision procedures need be in place.

In some embodiments, the binning electrical network comprises a plurality of electrical paths electrically connectable to the light source, wherein one electrical path of the plurality of electrical paths comprises a resistor with a resistance associated with predetermined characteristics of the light source, and wherein each of remaining electrical paths of the plurality of electrical paths comprises a resistor.

The resistor of each electrical path has a resistance that may be suitable for electrically driving a light source with some particular predetermined characteristics, that is, the resistance may be dependent on predetermined characteristics of a light source. The configurable resistance of the binning electrical network comprises the resistor of each electrical path, and one of the resistors may advantageously comprise a resistance that complies with the predetermined characteristics of the light source. Therefore, if the resistors are selected based on the predetermined characteristics of different light sources (that is, the resistance of the resistors are associated with one of the different predetermined characteristics) that may be installed on the lighting module, the lighting module may be configured so that a resistance of the electrical network corresponds to the predetermined characteristics of the light source that is installed.

The lighting module may be more costly due to the addition of one or more resistors that ultimately will not be necessary once the resistance of the binning electrical network has been configured, but as aforementioned this additional cost may be less than the cost of having a production line that only places one resistor with a resistance associated with the predetermined characteristics of the light source provided in the lighting module.

The electrical network and the configurable resistance thereof may be configured once the lighting module is provided with the light source. For example, the electrical network may be configured during a functional control test (FCT) procedure that tests whether the lighting module functions or operates correctly. In this sense, equipment provided for FCT procedures may be capable of configuring the electrical network based upon the light source installed on a lighting module.

In some embodiments, each electrical path of the plurality of electrical paths is electrically connected to the light source, each electrical path of the plurality of electrical paths being in parallel with each other, and each electrical path of the plurality of electrical paths further comprises a fuse resistor in series with the resistor.

The fuse resistors have a resistance (in the order of few ohms or less than 1 ohm) that is low compared with the resistance of the binning resistor (in the order of several hundreds of ohms or even greater than 1kΩ, such as 2kΩ, 3kΩ, 4kΩ or even greater) in a same electrical path, so it does not significantly affect the total impedance of the electrical path. While the fuse resistor is not melted, an electrical current may flow through the electrical path, whereas once the fuse resistor is melted, that is, once the fuse resistor is blown, an open circuit is provided and hence no electrical current may flow through the electrical path anymore.

A terminal of each electrical path of the plurality of electrical paths is electrically connected to the light source such that all electrical paths are in parallel; further, a second terminal of each electrical path of the plurality of electrical paths is electrically connected to the electrical driver module. Therefore, in order to configure the binning electrical network and the configurable resistance thereof according to the predetermined characteristics of the light source, in some of these embodiments the fuse resistor of the one electrical path of the plurality of electrical paths is not blown, and the fuse resistor of each of the remaining electrical paths of the plurality of electrical paths is blown thereby resulting in an open circuit.

In some embodiments, each electrical path of the plurality of electrical paths is electrically connected to the light source, each electrical path of the plurality of electrical paths being in parallel with each other, and for each of the remaining electrical paths of the plurality of electrical paths, a conductive track thereof and/or the resistor is disconnected by breakage thereby resulting in an open circuit. Preferably, the breakage comprises a laser cut or electrical breaking (e.g. voltage breaking).

The binning electrical network and the configurable resistance thereof may be configured by breaking part of some electrical paths, either by breaking a conductive track of the electrical path (each electrical path is provided on a printed circuit board in the form of conductive tracks whereon electronic components are soldered) or by burning a resistor. As part of an electrical path is broken, its impedance becomes an open circuit and hence no electrical current may flow (an electrical current with negligible intensity may flow through the electrical path since the open circuit is not perfect) through the electrical path anymore.

The disconnection of the electrical path by breakage is preferably produced by laser cutting the conductive track or by electrically breaking the resistor.

A terminal of each electrical path of the plurality of electrical paths is electrically connected to the light source such that all electrical paths are in parallel; further, a second terminal of each electrical path of the plurality of electrical paths is electrically connected to the electrical driver module.

In some embodiments, the binning electrical network further comprises a multiplexer electrically connected to the light source and to each electrical path of the plurality of electrical paths. In some embodiments, the binning electrical network further comprises a demultiplexer connected to the electrical driver module and to each electrical path of the plurality of electrical paths.

The binning electrical network and the configurable resistance thereof may be adjusted by means of data selectors either in the form of a multiplexer, a demultiplexer, or both (in a same embodiment).

A multiplexer may have as many inputs as there are electrical paths in the plurality of electrical paths, and an output for electrically connecting one of the inputs to, for instance, the light source. Further, the multiplexer comprises one or more inputs for selecting which input shall be electrically connected to the output (generally, the selection signals are provided as binary signals) thereby adjusting the configurable resistance of the binning electrical network.

The terminal of each electrical path not connected to the multiplexer may be connected to the same terminal of the other electrical paths, so the electrical paths may be arranged in parallel. A demultiplexer may be provided so as to connect its input (where the electrical driver module may connect to for instance) to one of the outputs of the demultiplexer (as many outputs as there are electrical paths, the free terminal of each electrical path may be connected to the outputs of the demultiplexer); the resistance of the binning electrical network may be adjusted with the connection of the input to one of the outputs, something that may be achieved by means of the selection inputs of the demultipelxer.

A demultiplexer may also be provided without the corresponding multiplexer, in which case the terminal of the electrical paths that is not connected to the demultiplexer is connected to the same terminal of the other electrical paths so as to be arranged in parallel.

In some embodiments, the binning electrical network further comprises an electrical connection between the one electrical path of the plurality of electrical paths and the light source, the electrical connection comprising one of: a wire bond, a ribbon bond, a jumper, and a trace.

For instance, during a functional control test procedure, or before the functional control test procedure takes place, a wire bond, a ribbon bond or a jumper may be provided so that the electrical driver module drives the light source through the appropriate electrical path of the plurality of electrical paths. Therefore, the binning electrical network and the configurable resistance thereof may be configured by providing the electrical connection between an electrical path and the light source.

In some embodiments, the binning electrical network comprises an electronic component with tunable resistance. Preferably, in these embodiments, the electronic component comprises a digitally programmable potentiometer or a variable resistor.

The tunable resistance of the electronic component may be varied analogically or, more preferably, digitally depending on the nature of the electronic component. The tunable resistance includes a resistance associated with the predetermined characteristics of the light source. By varying the tunable resistance of the electronic component, the resistance of the binning electrical network is adjusted so that it may have the value corresponding to the predetermined characteristics of the light source.

In some embodiments, the lighting module further comprises an at least second light source, and an at least second binning electrical network comprising a second configurable resistance. In these embodiments, the electrical driver module is further configured to supply an electrical current to the at least second light source through the at least second binning electrical network. In some of these embodiments, the lighting module further comprises additional light sources and additional binning electrical networks each comprising a configurable resistance.

There may be as many binning electrical networks as there are light sources so as to correctly drive every light source. In this sense, a first light source may be a first LED assigned to a first bin (that is, first predetermined characteristics or first brightness class), and a second light source may be a second LED assigned to a second bin (that is, second predetermined characteristics or second brightness class), so it is apparent that each of the first and second LEDs requires different binning resistors.

The binning electrical networks such as the at least second electrical network may, for instance, comprise:
a second plurality of electrical paths electrically connectable to the at least second light source, wherein one electrical path of the second plurality of electrical paths comprises a resistor with a resistance associated with predetermined characteristics of the at least second light source, wherein each of remaining electrical paths of the second plurality of electrical paths comprises a resistor; or
an electrical path electrically connected to the at least second light source and comprising an electronic component with tunable resistance, the tunable resistance at least including a resistance associated with predetermined characteristics of the at least second light source.

In some embodiments, the light source comprises at least one LED with the predetermined characteristics.

A second aspect of the invention relates to a method for configuring a lighting module for an automotive vehicle to electrically drive a light source thereof according to predetermined characteristics of the light source, the method comprising:
providing the lighting module for an automotive vehicle, the lighting module comprising:
   the light source; and
   an electrical driver module configured to supply an electrical current to the light source through a binning electrical network;
providing the binning electrical network, the binning electrical network comprising a configurable resistance.

In some embodiments, the binning electrical network comprises a plurality of electrical paths electrically connectable to the light source; wherein one electrical path of the plurality of electrical paths comprises a resistor with a resistance associated with the predetermined characteristics; and wherein each of remaining electrical paths of the plurality of electrical paths comprises a resistor. In these embodiments, the method further comprises electrically connecting at least one electrical path of the plurality of electrical paths to the light source.

The binning electrical network comprises a plurality of resistance values that may be selected for programming the binning electrical network. Depending on the predetermined characteristics of the light source included in the lighting module, one or another resistance value must be selected on the electrical network for driving the light source with an electrical current with an appropriate intensity. This is carried out by electrically connecting at least one electrical path of the plurality of electrical paths to the light source. The electrical connection may be provided during a functional control test procedure, either automatically (with one or more machines) or manually (e.g. an operator that provides such electrical connection by soldering components).

By electrically connecting an electrical path to, for instance, the light source it is understood electrically connecting one terminal of the electrical path to a terminal of another electrical path that is electrically connected to the light source.

In some embodiments, each electrical path of the plurality of electrical paths further comprises a fuse resistor in series with the resistor; and the method further comprises melting the fuse resistor of each of the remaining electrical paths of the plurality of electrical paths by supplying, at each of the remaining electrical paths, an electrical current adapted to melt the fuse resistor thereby resulting in an open circuit. Further, in these embodiments, electrically connecting the at least one electrical path of the plurality of electrical paths to the light source comprises electrically connecting each electrical path of the plurality of electrical paths to the light source, each electrical path of the plurality of electrical paths being in parallel with each other.

The fuse resistors may be melted or blown during a functional control test procedure, either automatically (with one or more machines) or manually (e.g. an operator that connects a voltage source to each electrical path that shall be disconnected so as to provide an electrical current with an intensity sufficient to melt the fuse resistors).

In some embodiments, the method further comprises: for each of the remaining electrical paths, disconnecting by breakage a conductive track thereof and/or the resistor thereby resulting in an open circuit, wherein the breakage preferably comprises laser cutting the conductive track or electrically breaking the resistor. Further, in these embodiments, electrically connecting the at least one electrical path of the plurality of electrical paths to the light source comprises electrically connecting each electrical path of the plurality of electrical paths to the light source, each electrical path of the plurality of electrical paths being in parallel with each other.

The electrical paths may be disconnected during a functional control test procedure, either automatically (with one or more machines) or manually (e.g. an operator that cuts with a laser the conductive tracks or connects a voltage source to each electrical path that shall be disconnected so as to provide an electrical current with an intensity sufficient to electrically break the resistors).

In some embodiments, the binning electrical network further comprises a multiplexer connected to the light source and to each electrical path of the plurality of electrical paths; and electrically connecting the at least one electrical path of the plurality of electrical paths to the light source comprises selecting, in the multiplexer, the one electrical path thereby electrically connecting the one electrical path to the light source.

In some embodiments, the binning electrical network further comprises a demultiplexer connected to the electrical driver module and to each electrical path of the plurality of electrical paths; and electrically connecting the at least one electrical path of the plurality of electrical paths to the light source comprises selecting, in the demultiplexer, the one electrical path thereby electrically connecting the electrical driver module to the one electrical path.

The electrical path in any of the multiplexer and the demultiplexer may be selected during a functional control test procedure, either automatically (with one or more machines) or manually (e.g. an operator that adjusts the voltage supplied to inputs of the multiplexer and/or demultiplexer corresponding to data selection).

In some embodiments, electrically connecting the at least one electrical path of the electrical network to the light source comprises providing, between the at least one electrical path and the light source, one of: at least one wire bond, at least one ribbon bond, at least one jumper, and at least one trace.

The electrical connection may be provided during a functional control test procedure, either automatically (with one or more machines) or manually (e.g. an operator that solders wire bonds, ribbon bonds, or that adjusts jumpers).

In some embodiments, the binning electrical network comprises an electronic component with tunable resistance, the electronic component preferably comprising a digitally programmable potentiometer or a variable resistor. Further, in these embodiments, electrically connecting the at least one electrical path of the plurality of electrical paths to the light source comprises varying the tunable resistance of the electronic component to a resistance associated with the predetermined characteristics.

The tunable resistance may be varied during a functional control test procedure, either automatically (with one or more machines) or manually (e.g. an operator that programs the electronic component such that the resistance it provides has a particular value within the range of resistance values the component may provide).

In some embodiments, the light source comprises at least one LED with the predetermined characteristics.

Further, similar advantages as described for the first aspect of the invention may also be applicable to this aspect of the invention.

A third aspect of the invention relates to a lighting device for an automotive lamp comprising a lighting module according to the first aspect of the invention.

A fourth aspect of the invention relates to an automotive lamp comprising a lighting device according to the third aspect of the invention. The automotive lamp may be one of: a headlamp, a turn signal lamp, and a tail lamp.

### BRIEF DESCRIPTION OF THE DRAWINGS

To complete the description and in order to provide for a better understanding of the invention, a set of drawings is provided. Said drawings form an integral part of the description and illustrate embodiments of the invention, which should not be interpreted as restricting the scope of the invention, but just as examples of how the invention can be carried out. The drawings comprise the following figures:
Figure 1 shows a schematic diagram of a lighting module in accordance with an embodiment of the invention.
Figure 2 diagrammatically shows an electrical network suitable for a lighting module in accordance with the present disclosure.
Figures 3A-3B diagrammatically show another electrical network suitable for a lighting module in accordance with the present disclosure.
Figures 4A-4B diagrammatically show another electrical network suitable for a lighting module in accordance with the present disclosure.
Figure 5 diagrammatically shows another electrical network suitable for a lighting module in accordance with the present disclosure.
Figure 6 diagrammatically shows another electrical network suitable for a lighting module in accordance with the present disclosure.
Figure 7 diagrammatically shows another electrical network suitable for a lighting module in accordance with the present disclosure.
Figure 8 diagrammatically shows another electrical network suitable for a lighting module in accordance with the present disclosure.
Figure 9 shows a portion of a PCB with an electrical network suitable for a lighting module in accordance with the present disclosure.
Figure 10 shows a portion of another PCB with an electrical network suitable for a lighting module in accordance with the present disclosure.
Figure 11 shows a portion of another PCB with an electrical network suitable for a lighting module in accordance with the present disclosure.
Figure 12 shows a portion of another PCB with an electrical network suitable for a lighting module in accordance with the present disclosure.
Figure 13 shows a portion of another PCB with an electrical network suitable for a lighting module in accordance with the present disclosure.

### DESCRIPTION OF A WAY OF CARRYING OUT THE INVENTION

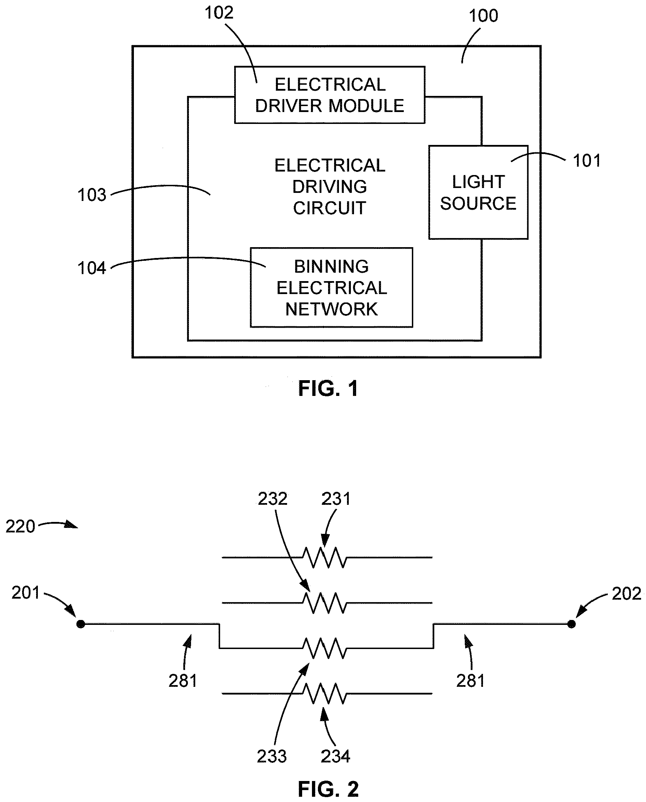

Figure 1 shows a schematic diagram of a lighting module 100 in accordance with an embodiment of the invention. The lighting module 100 comprises: a light source 101 such as at least one LED with predetermined characteristics, an electrical driver module 102 configured to supply an electrical current to the light source 101 or, in other words, configured to drive the light source 101, and an electrical driving circuit 103 in turn comprising a binning electrical network 104.

Both the light source 101 and the electrical driver module 102 are electrically connected to the electrical driving circuit 103. The electrical driver module 102 supplies a voltage to the electrical driving circuit 103 thereby resulting in an electrical current that drives the light source 101 connected thereto. The intensity of the electrical current depends on both the voltage supplied by the electrical driver module 102 and the electrical driving circuit 103. Typically, an electrical network 104 includes an electrical path with a resistor (sometimes referred to as binning resistor or R_{bin}) that modifies the electrical current driving the light source 101. The light source 101 may be correctly driven when the voltage and the electrical driving circuit 103 (including the electrical network 104) are adjusted according to the predetermined characteristics of the light source 101, namely, according to the bin assigned to the light source 101.

The binning electrical network 104 must be designed such that its impedance (particularly its resistance) may be configured to provide a resistance associated with the predetermined characteristics of the light source 101.

The electrical driving circuit 103 may be formed on a printed circuit board. The printed circuit board includes electronic components and conductive traces electrically connecting different nodes thereby providing different electrical paths for the currents to flow. There is at least one electrical path that electrically connects the electrical driver module 102 to the light source 101 through the electrical network 104.

Figure 2 shows an electrical network 220. The electrical network 220 comprises a first terminal 201 and a second terminal 202 for electrical connection of the electrical network 220 to an electrical driving circuit of a lighting module, for example the electrical driving circuit 103 of the lighting module 100 of Figure 1. For instance, an electrical driver module (such as the electrical driver module 102 of Figure 1) may be electrically connected to the electrical network 220 at the first terminal 201, and a light source (such as the light source 101 of Figure 1) may be electrically connected to the electrical network 220 at the second terminal 202, or vice versa; in any of both cases, between the electrical driver module and the electrical network 220, and between the light source and the electrical network 220, there may be different electronic components and/or electrical paths (that is, the electrical driver module and/or the light source may not be directly connected to the electrical network 220 at the first terminal 201 or the second terminal 202).

The electrical network 220 further comprises a plurality of electrical paths, in this example four electrical paths (each of them being illustrated comprising a resistor 231-234) that may be used for configuring the electrical network 220 and, accordingly, the lighting module comprising the electrical network 220 to electrically drive a light source thereof according to predetermined characteristics of the light source. Each of the four electrical paths are electrically connectable to the electrical driver module and to the light source, but in this embodiment only one of the four electrical paths (the electrical path with the resistor 233 that comprises a resistance associated with the predetermined characteristics of the light source) is electrically connected to both the electrical driver module and to the light source with electrical connections 281. The remaining electrical paths (the electrical paths with resistors 231, 232 and 234) are not electrically connected to terminals 201 and 202. The electrical connections 281 may comprise wire bonds, ribbon bonds, jumpers or zero-ohm resistors, or conductive traces (of the printed circuit board).

For a same voltage supplied by the electrical driver module, depending on the electrical path connected to the electrical driver module and the light source, a different electrical current will drive the light source. In the case of the electrical network 220, the electrical current is conditioned by the resistor 233 and the resistance thereof.

Each electrical path at least includes a binning resistor 231-234 such that each different binning resistor comprises a resistance associated with different predetermined characteristics or brightness classes.

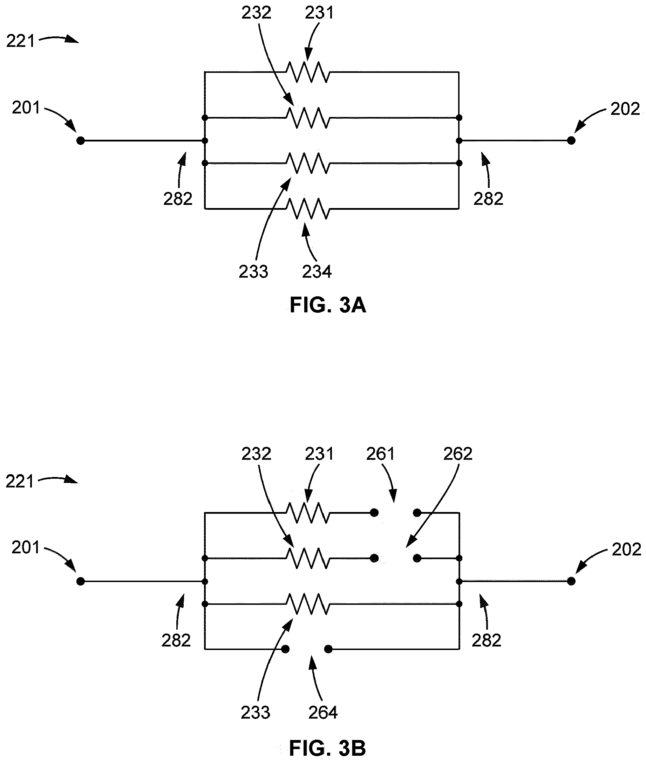

Figures 3A and 3B show another electrical network 221. The electrical network 221 comprises a plurality of electrical paths (with four electrical paths), each electrical path in turn comprising a resistor 231-234. All four electrical paths are in parallel with each other due to the electrical connections 282 (e.g. in the form of wire bonds, ribbon bonds, jumpers or zero-ohm resistors, or conductive traces). A first terminal of all four resistors 231-234 share a common potential (the one of the first terminal 201), and a second terminal of all four resistors 231-234 share another common potential (the one of the second terminal 202).

Since only one electrical path shall connect the electrical driver module to the light source, some electrical paths may be disconnected by providing an open circuit as shown in Figure 3B. Particularly, a first electrical path that comprises the resistor 233 is not altered, whereas remaining electrical paths of the plurality of electrical paths are disconnected by breakage thereby resulting in respective open circuits 261, 262 and 264. Two electrical paths (the ones comprising the resistors 231 and 232) have the conductive traces thereof broken, whereas another electrical path (the one comprising the resistor 234) has its resistor 234 broken.

In some embodiments, only the conductive traces are broken; in some other embodiments, only the resistors are broken; and in some embodiments such as the one depicted in Figure 3B, at least one resistor and at least one conductive trace are both broken. Preferably, the breakage comprises laser cutting the conductive traces and/or electrically breaking the resistors.

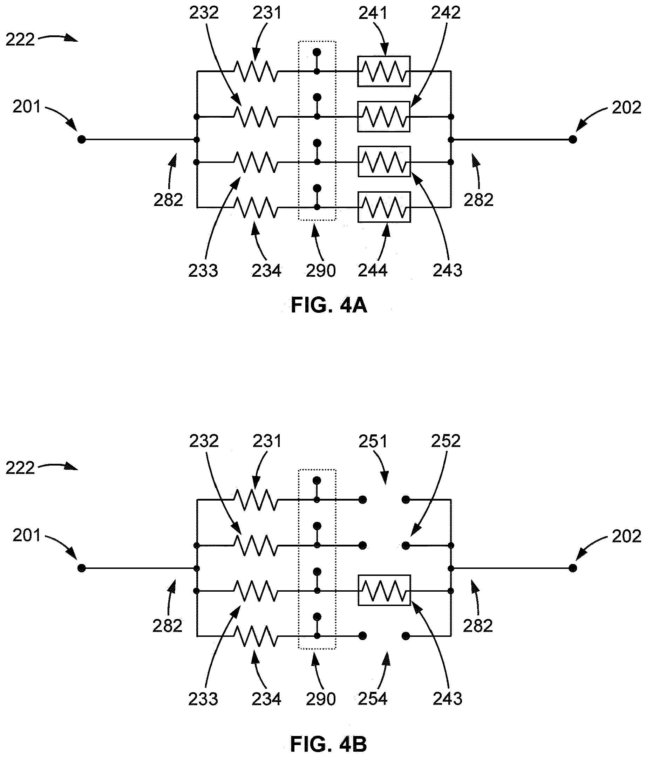

Figures 4A and 4B show another electrical network 222. The electrical network 222 comprises a plurality of electrical paths (with four electrical paths), each electrical path in turn comprising a resistor 231-234 in series with a fuse resistor 241-244. Further, each of the four electrical paths also comprises a terminal 290 for supplying a voltage, if necessary, to disconnect the respective electrical path by melting the respective fuse resistor 241-244. All four electrical paths are in parallel with each other due to the electrical connections 282.

Since only one electrical path shall connect the electrical driver module to the light source, some electrical paths may be disconnected by providing an open circuit as shown in Figure 4B. Particularly, one electrical path that comprises both the resistor 233 and the fuse resistor 243 is not altered. For the remaining electrical paths of the plurality of electrical paths, each electrical path is disconnected by melting the fuse resistors 241, 242 and 244 thereby resulting in respective open circuits 251, 252 and 254.

The fuse resistors 241-244 are fuses with a low resistance (few ohms, e.g. 5Ω, 2Ω, 1Ω, or even less than 1Ω, e.g. 500mΩ, 200mΩ, or even less). When an electrical current with high intensity (e.g. 0.5A, 0.8A, 1.0A, 1.5A, 2.0A, or even greater) flows through the fuse resistor (when it is not blown), it melts the fuse (the fuse resistor is then blown) thereby resulting in an open circuit. Therefore, the electrical network 222 may be configured by blowing some of the fuse resistors 241-244 such that only one electrical path remains connected (due to the existence of an open circuit 251, 252 and 254 in the remaining electrical paths).

If the electrical path comprising the resistor 233 and the fuse resistor 243 has a resistance or impedance associated with predetermined characteristics of a light source, each of the fuse resistors 241, 242 and 244 needs to be blown as shown in Figure 4B. Accordingly, when the electrical network 270 is being configured, a voltage is provided at the terminal 290 of the respective electrical paths during a short period of time (e.g. 0.5 seconds, 1 second, 2 seconds, etc.) so that an electrical current of a high intensity (due to the small resistance) flows through the fuse resistor 241, 242 or 244 until it melts. Once the fuse resistor has melted, if the voltage is still supplied at the terminal it does not damage the rest of the electrical network since the electrical current decreases in intensity as it now flows through the resistor 231, 232 or 234. In this sense, each of the resistors 231-234 has a resistance larger than that of the fuse resistors 241-244, so for a same voltage (e.g. 12 volts), the electrical current will have a lower intensity once the electrical current cannot flow through the fuse resistor 241-244 anymore because it is blown.

The electrical network 222 of Figure 4B illustrates open circuits 251, 252 and 254 resulting from applying a voltage at the terminal 290 of each of the respective electrical paths. Accordingly, the electrical current provided by an electrical driver module will depend on the electrical path that comprises the resistor 233 and the fuse resistor 243. Since the fuse resistor 243 features a low resistance, this resistance is negligible and the effective impedance of the electrical path (and of the electrical network 271) is that of the resistor 233 whose resistance is associated with the predetermined characteristics of the light source.

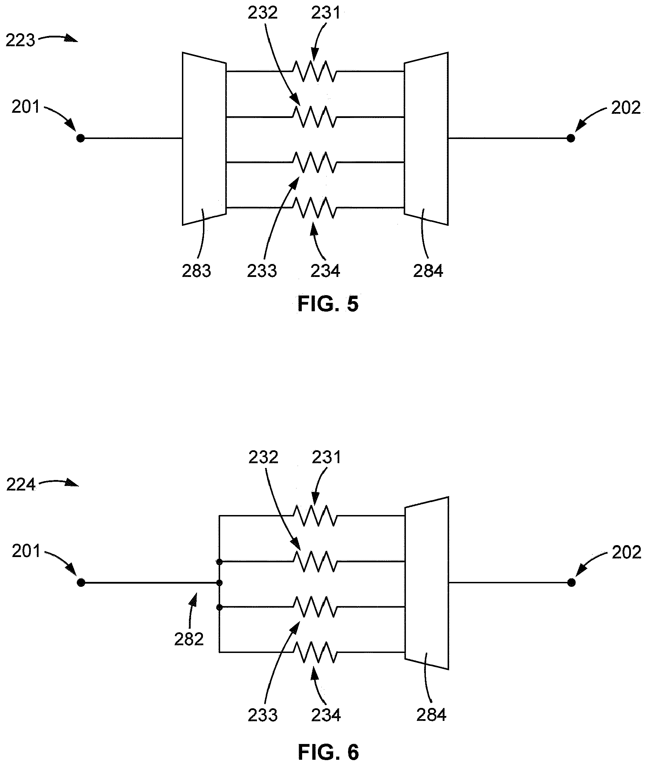

Figure 5 shows another electrical network 223. The electrical network 223 comprises a plurality of electrical paths (with four electrical paths), each electrical path in turn comprising a resistor 231-234. The electrical network 223 further comprises a demultiplexer 283 for electrically connecting the first terminal 201 to one electrical path of the plurality of electrical paths, and a multiplexer 284 for electrically connecting one electrical path of the plurality of electrical paths to the second terminal 202, particularly a same electrical path selected by the demultiplexer 283.

Both the demultiplexer 283 and the multiplexer 284 are provided with one or more inputs (not illustrated) for selecting one of the outputs of the demultiplexer 283 and one of the inputs of the multiplexer 284. The resistance of the electrical network 223 is then configured by selecting in both the demultiplexer 283 and the multiplexer 284 the appropriate electrical path for driving a light source, that is, the electrical path comprising the resistor with a resistance associated with predetermined characteristics of the light source.

Figure 6 shows another electrical network 224 similar to the electrical network 223 of Figure 5. The electrical network 224 comprises electrical connection 282 for connecting each of the plurality of electrical paths to the first terminal 201. Then, by selecting one of the electrical paths in the multiplexer 284, only that electrical path will be connected to both an electrical driver module and a light source thereby adjusting the configurable resistance of the electrical network 223.

In other embodiments, an electrical network comprises a demultiplexer 283 and an electrical connection 282 that replaces the multiplexer 284, however the electrical network operates in a way similar to that of the electrical network 224.

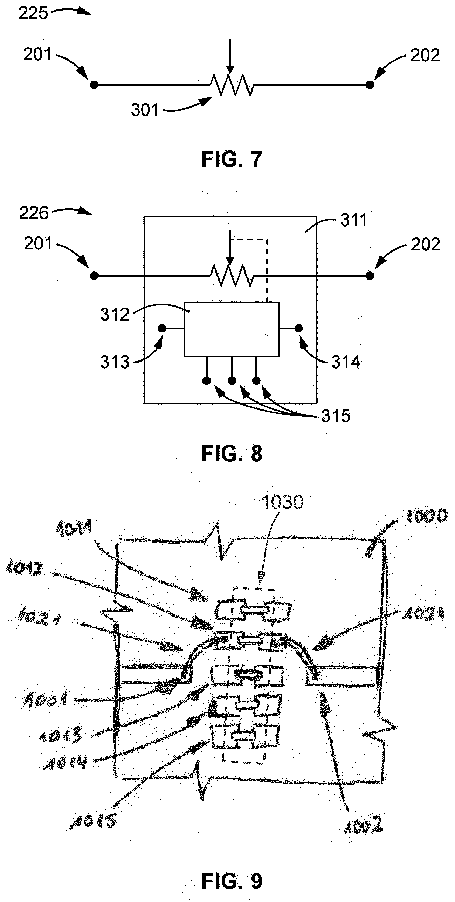

Figure 7 shows another electrical network 225 comprising an electrical path between first and second terminals 201 and 202, the electrical path comprising an electronic component 301 with tunable resistance. The electronic component 301 may be a variable resistor such as a potentiometer that permits tuning its resistance. The range of resistances that may be selected from the electronic component 301 at least includes a resistance associated with predetermined characteristics of a light source that may be electrically connected to the electrical network 225.

Figure 8 shows another electrical network 226 similar to the electrical network 225. The electrical network 226 comprises an electronic component 311 with tunable resistance. The resistance of the electronic component 311 is digitally modified by means of a component 312 configured to tune the resistance of the electronic component 311. The component 312 comprises several inputs, such as inputs 313 and 314 for powering the component 312, and inputs 315 for tuning the resistance of the electronic component 311. The range of resistances that may be selected from the electronic component 311 at least includes a resistance associated with predetermined characteristics of a light source that may be electrically connected to the electrical network 226.

Any of the electrical networks 220-226 may be included in a lighting module such as the lighting module 100 of Figure 1. Particularly, any of the electrical networks 220-226 may be used as the electrical network 104 included in the electrical driving circuit 103 so as to configure the lighting module 100 to electrically drive the light source 101 according to the predetermined characteristics of the light source 101.

Even though the electrical networks 220-224 comprise a plurality of electrical paths having four electrical paths, it is readily apparent that other electrical networks may comprise two, three, four, five, or more than five electrical paths without departing from the scope of the present disclosure.

Figure 9 shows a portion of a printed circuit board 1000 comprising an electrical network that includes a configurable resistance. The electrical network comprises a first terminal 1001, a second terminal 1002, and a plurality of electrical paths (in the form of conductive tracks): five electrical paths 1011-1015 each comprising a binning resistor 1030.

The electrical network configures a lighting module comprising the electrical network to electrically drive a light source of the lighting module according to predetermined characteristics of the light source. This is carried out by adjusting the configurable resistance of the electrical network resulting from providing electrical connections 1021 (comprising, for instance, wire bonds) between the first terminal 1001 and one electrical path such as the electrical path 1012, and between the one electrical path 1012 and the second terminal 1002. The remaining electrical paths do not affect the impedance of the electrical network since they are arranged as open circuits.

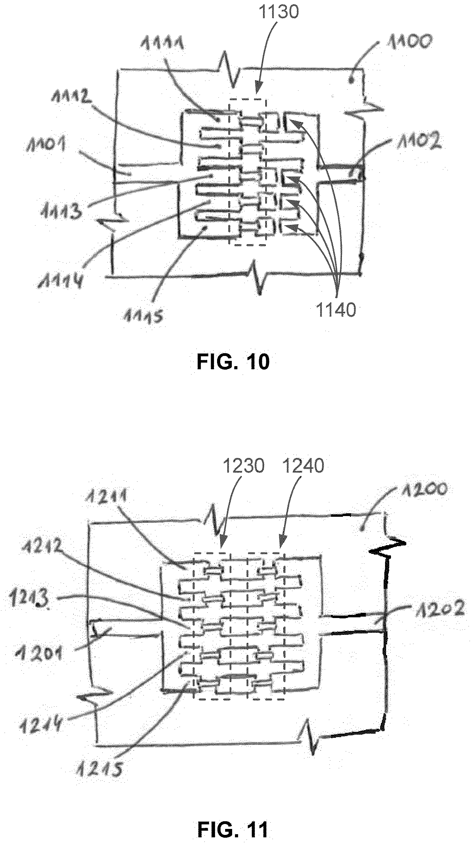

Figure 10 shows a portion of another printed circuit board 1100 comprising an electrical network. The electrical network comprises a first terminal 1101, a second terminal 1102, and a plurality of electrical paths (in the form of conductive tracks): five electrical paths 1111-1115 each comprising a binning resistor 1130. Initially, each of the five electrical paths 1111-1115 are electrically connected to both the first terminal 1101 and the second terminal 1102.

The electrical network configures a lighting module comprising the electrical network to electrically drive a light source of the lighting module according to predetermined characteristics of the light source. This is carried out by adjusting the configurable resistance of the electrical network resulting from laser cutting several electrical paths 1111, 1113-1115 so as to disconnect them by breakage 1140, which in turn results in respective open circuits. The only electrical path 1112 that is still electrically connected to the first and second terminals 1101 and 1102 is provided with a binning resistor 1130 associated with the predetermined characteristics of the light source so that the electrical current driving the light source has the appropriate intensity.

Figure 11 shows a portion of a printed circuit board 1200 comprising an electrical network. The electrical network comprises a first terminal 1201, a second terminal 1202, and a plurality of electrical paths (in the form of conductive tracks): five electrical paths 1211-1215 each comprising a binning resistor 1230 in series with a fuse resistor 1240.

The electrical network configures a lighting module comprising the electrical network to electrically drive a light source of the lighting module according to predetermined characteristics of the light source. This is carried out by programming the configurable resistance of the electrical network resulting from melting several fuse resistors 1240 so as to provide respective open circuits. The only electrical path that is still electrically connected to the first and second terminals 1101 and 1102 (because the respective fuse resistor 1240 has not been blown) is provided with a binning resistor 1230 associated with the predetermined characteristics of the light source so that the electrical current driving the light source has the appropriate intensity.

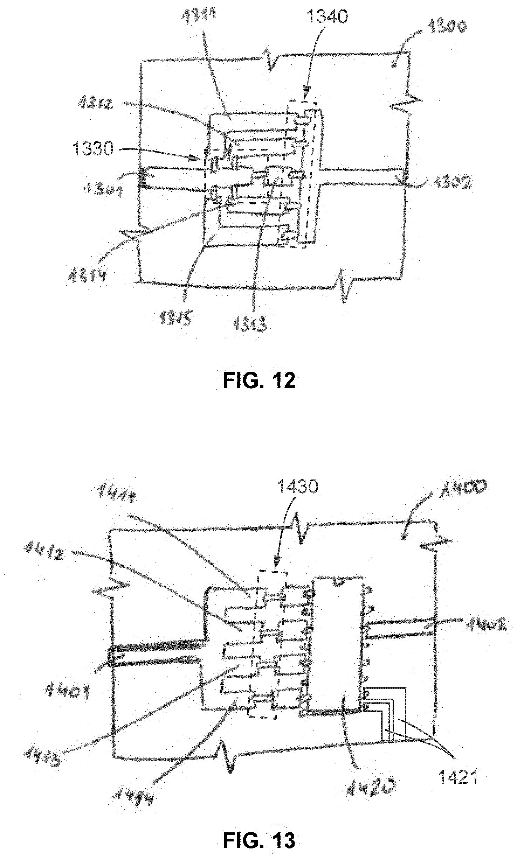

Figure 12 shows a portion of a printed circuit board 1300 comprising an electrical network. The electrical network comprises a first terminal 1301, a second terminal 1302, and a plurality of electrical paths (in the form of conductive tracks): five electrical paths 1311-1315 each comprising a binning resistor 1330 in series with a fuse resistor 1340.

The electrical network of Figure 12 works in the same way as the electrical network of Figure 11, however the electrical paths 1311-1315 are arranged on the printed circuit board 1300 with a different, more compact, layout.

Figure 13 shows a portion of a printed circuit board 1400 comprising an electrical network. The electrical network comprises a first terminal 1401, a second terminal 1402, and a plurality of electrical paths (in the form of conductive tracks): four electrical paths 1411-1414 each comprising a binning resistor 1430. The electrical network further comprises a demultiplexer 1420 electrically connected to each of the four electrical paths 1411-1414 and to the second terminal 1402.

The electrical network configures a lighting module comprising the electrical network to electrically drive a light source of the lighting module according to predetermined characteristics of the light source. This is carried out by programming the configurable resistance of the electrical network resulting from modifying selection signals of the demultiplexer 1420 (terminals 1421) that modify which one of the electrical paths 1411-1414 is electrically connected to the second terminal 1402, whereas the remaining electrical paths 1411-1414 are not electrically connected to the second terminal 1402.

In this text, the term "comprises" and its derivations (such as "comprising", etc.) should not be understood in an excluding sense, that is, these terms should not be interpreted as excluding the possibility that what is described and defined may include further elements, steps, etc.

The invention is obviously not limited to the specific embodiment(s) described herein, but also encompasses any variations that may be considered by any person skilled in the art (for example, as regards the choice of materials, dimensions, components, configuration, etc.), within the general scope of the invention as defined in the claims.

## Claims

1. Lighting module (100) for an automotive vehicle, comprising:
a light source (101);
a binning electrical network (104, 220-226) comprising a configurable resistance; and
an electrical driver module (102) configured to supply an electrical current to the light source (101) through the binning electrical network (104, 220-226).

2. Lighting module (100) according to claim 1, wherein the binning electrical network (104, 220-224) comprises a plurality of electrical paths (1011-1015, 1111-1115, 1211-1215, 1311-1315, 1411-1414) electrically connectable to the light source (101); wherein one electrical path of the plurality of electrical paths (1011-1015, 1111-1115, 1211-1215, 1311-1315, 1411-1414) comprises a resistor (233, 1030, 1130, 1230, 1330, 1430) with a resistance associated with predetermined characteristics of the light source (101); and wherein each of remaining electrical paths of the plurality of electrical paths (1011-1015, 1111-1115, 1211-1215, 1311-1315, 1411-1414) comprises a resistor (231-234, 1030, 1130, 1230, 1330, 1430).

3. Lighting module (100) according to claim 2, wherein each electrical path of the plurality of electrical paths (1111-1115, 1211-1215, 1311-1315) is electrically connected to the light source (101), each electrical path of the plurality of electrical paths (1111-1115, 1211-1215, 1311-1315) being in parallel with each other; and wherein each electrical path of the plurality of electrical (1211-1215, 1311-1315) paths further comprises a fuse resistor (241-244, 1240, 1340) in series with the resistor (231-234, 1230, 1330).

4. Lighting module (100) according to claim 2, wherein each electrical path of the plurality of electrical paths (1111-1115, 1211-1215, 1311-1315) is electrically connected to the light source (101), each electrical path of the plurality of electrical paths (1111-1115, 1211-1215, 1311-1315) being in parallel with each other; and wherein for each of the remaining electrical paths of the plurality of electrical paths (1111-1115), a conductive track thereof and/or the resistor is disconnected by breakage thereby resulting in an open circuit (261, 262, 264, 1140), the breakage preferably comprising a laser cut or electrical breaking.

5. Lighting module (100) according to claim 2, wherein the binning electrical network (104, 223-224) further comprises a multiplexer (284, 1420) electrically connected to the light source (101) and to each electrical path of the plurality of electrical paths (1411-1414).

6. Lighting module (100) according to claim 2, wherein the binning electrical network (104, 220-222) further comprises an electrical connection (281, 1021) between the one electrical path of the plurality of electrical paths (1011-1015) and the light source (101), the electrical connection (281, 1021) comprising one of: a wire bond, a ribbon bond, a jumper, and a trace.

7. Lighting module (100) according to claim 1, wherein the binning electrical network (104, 225-226) comprises an electronic component (301, 311) with tunable resistance, the electronic component (301, 311) preferably comprising a digitally programmable potentiometer or a variable resistor.

8. Lighting module (100) according to any of claims 1-7, further comprising:
an at least second light source (101); and
an at least second binning electrical network (104, 220-226) comprising a second configurable resistance;
wherein the electrical driver module (102) is further configured to supply an electrical current to the at least second light source (101) through the at least second binning electrical network (104, 220-226).

9. Method for configuring a lighting module (100) for an automotive vehicle to electrically drive a light source (101) thereof according to predetermined characteristics of the light source (101), the method comprising:
providing the lighting module (100) for an automotive vehicle, the lighting module (100) comprising:
the light source (101); and
an electrical driver module (102) configured to supply an electrical current to the light source (101) through a binning electrical network (104, 220-226);
providing the binning electrical network (104, 220-226), the binning electrical network (104, 220-226) comprising a configurable resistance.

10. Method according to claim 9, wherein:
the binning electrical network (104, 220-224) comprises a plurality of electrical paths (1011-1015, 1111-1115, 1211-1215, 1311-1315, 1411-1414) electrically connectable to the light source (101);
one electrical path of the plurality of electrical paths (1011-1015, 1111-1115, 1211-1215, 1311-1315, 1411-1414) comprises a resistor (233, 1030, 1130, 1230, 1330, 1430) with a resistance associated with the predetermined characteristics of the light source (101);
each of remaining electrical paths of the plurality of electrical paths (1011-1015, 1111-1115, 1211-1215, 1311-1315, 1411-1414) comprises a resistor (231-234, 1030, 1130, 1230, 1330, 1430); and
the method further comprises electrically connecting at least one electrical path of the plurality of electrical paths (1011-1015, 1111-1115, 1211-1215, 1311-1315, 1411-1414) to the light source (101).

11. Method according to claim 10, wherein:
each electrical path of the plurality of electrical paths (1211-1215, 1311-1315) further comprises a fuse resistor (241-244, 1240, 1340) in series with the resistor (231-234, 1230, 1330); and the method further comprises melting the fuse resistor (241-244, 1240, 1340) of each of the remaining electrical paths of the plurality of electrical paths (1211-1215, 1311-1315) by supplying, at each of the remaining electrical paths, an electrical current adapted to melt the fuse resistor (241-244, 1240, 1340) thereby resulting in an open circuit (251, 252, 254); and
electrically connecting the at least one electrical path of the plurality of electrical paths (1011-1015, 1111-1115, 1211-1215, 1311-1315, 1411-1414) to the light source (101) comprises electrically connecting each electrical path of the plurality of electrical paths (1111-1115, 1211-1215, 1311-1315) to the light source (101), each electrical path of the plurality of electrical paths (1111-1115, 1211-1215, 1311-1315) being in parallel with each other.

12. Method according to claim 10, further comprising: for each of the remaining electrical paths, disconnecting by breakage a conductive track thereof and/or the resistor thereby resulting in an open circuit (261, 262, 264, 1140), wherein the breakage preferably comprises laser cutting the conductive track or electrically breaking the resistor;
wherein electrically connecting the at least one electrical path of the plurality of electrical paths (1011-1015, 1111-1115, 1211-1215, 1311-1315, 1411-1414) to the light source (101) comprises electrically connecting each electrical path of the plurality of electrical paths (1111-1115, 1211-1215, 1311-1315) to the light source (101), each electrical path of the plurality of electrical paths (1111-1115, 1211-1215, 1311-1315) being in parallel with each other.

13. Method according to claim 10, wherein the binning electrical network (104, 223-224) further comprises a multiplexer (284, 1420) connected to the light source (101) and to each electrical path of the plurality of electrical paths (1411-1414); and
electrically connecting the at least one electrical path of the plurality of electrical paths (1011-1015, 1111-1115, 1211-1215, 1311-1315, 1411-1414) to the light source (101) comprises selecting, in the multiplexer (1411-1414), the one electrical path thereby electrically connecting the one electrical path to the light source (101).

14. Method according to claim 10, wherein the binning electrical network (104, 225-226) comprises an electronic component (301, 311) with tunable resistance, the electronic component (301, 311) preferably comprising a digitally programmable potentiometer or a variable resistor; and
wherein electrically connecting the at least one electrical path of the plurality of electrical paths (1011-1015, 1111-1115, 1211-1215, 1311-1315, 1411-1414) to the light source (101) comprises
varying the tunable resistance of the electronic component (301, 311) to a resistance associated with the predetermined characteristics.

15. Lighting module (100) according to any of claims 2-7, or method according to any of claims 9-14, wherein the light source (101) comprises at least one LED with the predetermined characteristics.
